# EUROPEAN PATENT SPECIFICATION

(11) **EP 0 363 670 B1**
(45) Date of publication and mention of the grant of the patent: **13.12.1995**
(21) Application number: 89117026.8
(22) Date of filing: 14.09.1989
(51) Int. Cl.: H01L 29/78

(54) **MOS field-effect transistor**
MOS-Feldeffekttransistor
Transistor MOS à effet de champ

(30) Priority: 14.09.1988 JP 231058/88
(43) Date of publication of application: 18.04.1990
(73) Proprietor: KABUSHIKI KAISHA TOSHIBA, Kawasaki-shi, Kanagawa-ken 210 (JP)
(72) Inventor: Mikata, Yuuichi c/o Intellectual Property Division, Minato-ku Tokyo 105 (JP); Usami, Toshiro c/o Intellectual Property Division, Minato-ku Tokyo 105 (JP)
(74) Representative: Lehn, Werner, Dipl.-Ing.

(56) References cited:
- EP-A- 0 020 929
- US-A- 4 470 060
- PATENT ABSTRACTS OF JAPAN vol. 7, no. 200 (E-196)(1345) 03 September 1983 & JP-A-58 97868
- PATENT ABSTRACTS OF JAPAN vol. 10, no. 340 (E-455)(2396) 18 November 1986 & JP-A-61 144875

## Description

### Background of the Invention

### [Field of the Invention]

The present invention relates to a semiconductor device comprising MOS type field effect transistors (hereinafter referred to as MOS FETs) and, in particular, to a structure and material of the MOS FET.

### [Description of the Related Art]

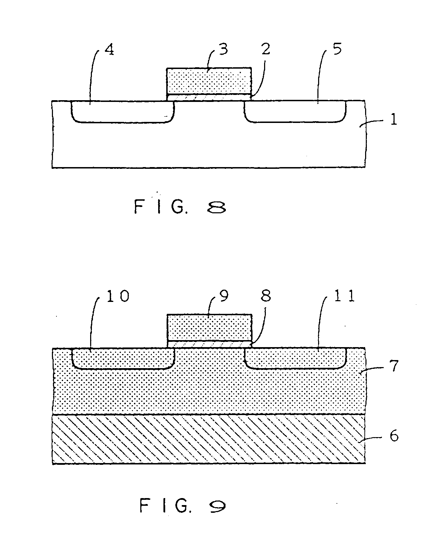

Fig. 8 shows an MOS FET of a background art. As shown in Fig. 8, oxide film 2 is formed on semiconductor substrate 1, and gate electrode 3 is further formed on film 2. At both sides of gate electrode 3, impurities such as boron or arsenic are diffused into substrate 1 so that p-n junctions are formed therebetween. Thereafter, source and drain regions 4 and 5 are formed. Conventionally, a silicon single crystal is used for the substrate of MOS FETs.
Fig. 9 shows another MOS FET of a second background art. As shown in Fig. 9, polysilicon layer 7 is formd on insulating substrate 6, and the MOS FET structure as shown in Fig. 8 is further formed on polysilicon layer 7. Such a structure can be adapted to a liquid crystal display device or the like.

In Fig. 9 polysilicon layer 7 is deposited on insulating substrate 6. Gate oxide film 8 and gate electrode 9 are subsequently stacked on polysilicon layer 7. Thereafter, impurities such as boron or arsenic are diffused at the both sides of the stacked layer, so that source and drain regions 10 and 11 are formed. Then, an MOS FET structure is obtained wherein a conductive channel forming area is formed by the polysilicon layer which is parallel to the main plane of the substrate.

When the MOS FET of Fig. 9 is used as a circuit element contained in an LSI, a problem occurs.

More specifically, when the MOS FET is to be formed, the source and drain regions are obtained by a thermal diffusion of p- or n-type impurities, or by an ion implantation of such impurities. Thereafter, a heat treatment process such as a passivasion film forming process is normally executed to manufacture an LSI. Such a heat treatment process, however, invites unintentional diffusion of the impurities at the source and drain regions.

Conventionally, a polysilicon involves grain boundaries at which many dangling bonds and/or many vacancies exist. These dangling bonds and/or vacancies accelerate the speed of a thermal diffusion. (Roughly speaking, a thermal diffusion coefficient of impurities in a polysilicon is several to several tens the number of a thermal diffusion coefficient of impurities in a single crystal silicon.) For this reason, when the distance between the source and the drain becomes small, the source could be short-circuited to the drain by the thermal diffusion in the case of Fig. 9, even if a manufacturing technique ensures no short-circuiting in the case of Fig. 8.

According to a current LSI process, the length of an impurity diffusion in the case of Fig. 8 is an order of about 10⁻⁴ mm (about 1000 Å). Consequently, no problem occurs when the distance between the source and the drain is about 1 »m. However, the length of an impurity diffusion in the case of Fig. 9 is an order of about 1 »m, thereby causing the problem or said short-circuiting This problem cannot be avoided even if insulating substrate 6 of Fig. 9 is made of a single crystal silicon.

As mentioned above, it is hard to reduce the length of a conductive channel forming area formed in a polysilicon of an MOS FET, because a thermal diffusion of impurities of the source and drain regions at the conductive channel forming area is so large. In other words, according to a currently availabe LSI technique, it is very difficult to minimize the size of an MOS FET along its lateral direction.

EP-A-0 020 929 discloses a vertical structure FET comprising an NPN-layered polycrystalline silicon projection formed by deposition on an insulating substrate. An oxide layer is grown on the side walls of the projection and, after contact holes for the source and drain regions have been etched, contact metallurgy for the source, drain and gate is formed over the oxide layer.

Similarly, Patent Abstracts of Japan, Vol. 10, no. 340 discloses an MOS transistor having successive NPN Si layers on an SiO₂ oxide film on a Si substrate, with a gate oxide film formed on a vertical edge of the NPN layer and a gate electrode on the gate oxide film.

In Patent Abstracts of Japan, Vol. 7, no. 200, a semiconductor device in which the carriers travel in the vertical direction relative to the substrate comprises, successively, a drain, gate and source formed on the substrate with a vertical gate electrode.

Finally, in US-A-4,470,060, an FET is disclosed having successive stacked semiconductor layers on a substrate forming a source, gate and drain. A gate electrode is provided on a vertical face of the stack, separated from the vertical face by an insulating layer.

### Summary of the invention

It is accordingly an object of the present invention to provide a semiconductor device comprising an MOS FET having a conductive channel forming area formed in a semiconductor material, e.g. polysilicon, wherein the size of the MOS FET along its lateral direction can be effectively reduced.

The present invention provides a semiconductor device having a MOS transistor structure, comprising: a substrate having a surface on which the MOS transistor structure is formed; a film formed on the surface of said substrate; a projection of polysilicon of first conductivity type having grain boundaries and formed on the film, said projection having a side wall extending in a direction substantially perpendicular to the surface of said substrate, a bottom portion in contact with the film and a top portion located opposite to the bottom portion; a first semiconductor region of second conductivity type formed on the film and located in contact with the bottom portion of said projection, said first region constituting the drain of said transistor structure; a gate region located along the extending direction of the side wall of said projection; a second semiconductor region of a second conductivity type located on top of and in contact with the top portion of said projection and constituting the source of said transistor structure; and an insulating film provided between the side wall of said projection and said gate region.

Further features of the invention are apparent from dependent claims 2 to 4.

The semiconductor device may comprise a semiconductor substrate or an insulating substrate on which a projection is formed via a given film. In a preferred embodiment, a pair of gate electrodes are provided so that one of the gate electrodes faces the other thereof, via side walls of the projection and gate oxide films. A conductive channel forming area is formed at the side walls of the projection, so that the extending direction of the channel is parallel to the thickness direction of the substrate.

The above-mentioned given film located between the projection and the substrate can be made of a semiconductor film or a laminate layer of a semiconductor film and an insulating film when a semiconductor substrate is adapted. When an insulating substrate is adapted, the given film can be made of a semiconductor film.

The above-mentioned polysilicon having grain boundaries may be a conventional polysilicon whose grain size is not limited to a specific value.

According to an MOS FET having the above-mentioned configuration, the conductive channel forming area is provided along a direction of the thickness of the substrate, or along a vertical direction perpendicular to the substrate. Then, the channel length of the MOS FET can be effectively increased while avoiding increase in size along a lateral direction parallel to the main surface of the substrate.

Even if a thermal diffusion of impurities of the source and drain regions at the conductive channel forming area is relatively larger than that in the case of a single crystal silicon, when the vertical length (height) of the projection, i.e., the length of the channel, is preselected to be large, it is possible to avoid occurrence of short-circuiting between the source and drain regions due to a thermal diffusion. Thus, the size of the MOS FET along its lateral direction can be readily reduced.

The MOS FET of the present invention can be provided with a pair of gate electrodes in which the projection is sandwiched.

According to an embodiment of the present invention, two opposite conductive channel forming areas can be formed within one projection (common base region). At the edges of the projection, source and drain regions are respectively formed so that one or more MOS FETs are constructed. In this case, either the source regions or the drain regions may be constituted as a common region. Or, both the source regions and the drain regions may be separated from one another. According to the above configuration, an effective area for forming active circuit elements on the main plane of the substrate can be materially increased, to thereby obtain a high-integrating density semiconductor device.

### Brief Description of the Drawings

Fig. 1 is a sectional view of an MOS FET according to an embodiment of the present invention;
Fig. 2 is a plane view of the MOS FET shown in Fig. 1;
Figs. 3 to 6 are sectional views illustrating the manufacturing process of the MOS FET shown in Figs. 1 and 2;
Fig. 7 is a plan view of the MOS FET shown in Fig. 6;
Fig. 8 shows an MOS FET or a background art; and
Fig. 9 shows an MOS FET of another background art.

### Description of the Preferred Embodiments

Preferred embodiments of this invention will be described with reference to the accompanying drawings. In the description the same or functionally equivalent elements are denoted by the same or similar reference numerals, to thereby simplify the description.

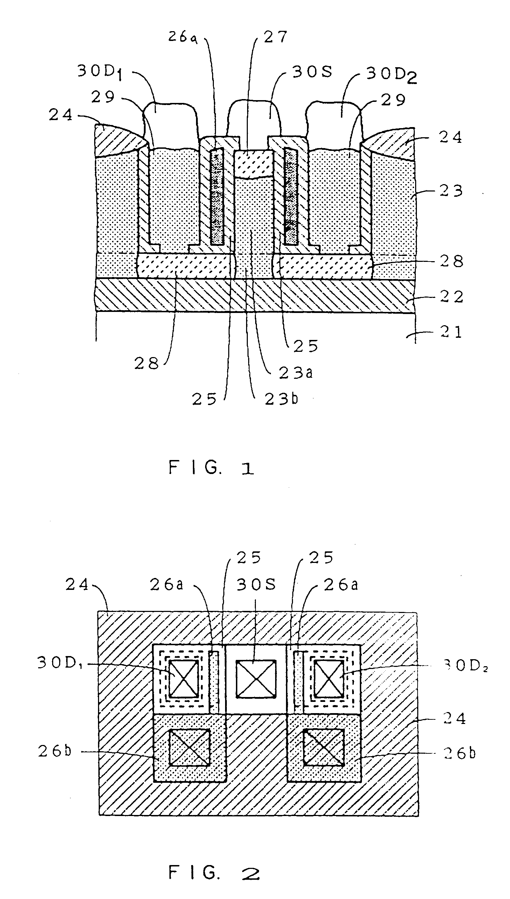

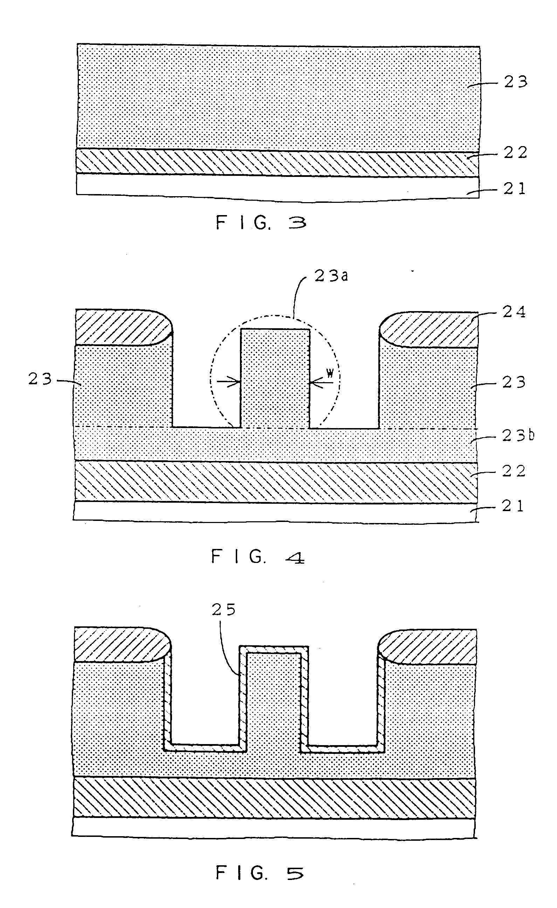

Fig. 1 is a sectional view of an MOS FET according to an embodiment of the present invention. Fig. 2 is a plan view of the MOS FET shown in Fig. 1. Figs. 3-7 illustrate how the MOS FET of the above embodiment is manufactured.

As shown in Fig. 3, single crystal silicon substrate 21 having the Miller indices (0 1 1) and resistivity 10 Ω.cm is prepared. On substrate 21, oxide film 22 having a thickness of 0.5 »m is formed by a thermal oxidation. Polysilicon layer 23 having a thickness of 2 »m is deposited on film 22 by an LPCVD (low pressure chemical vapor deposition) method at 700 deg. Celsius.

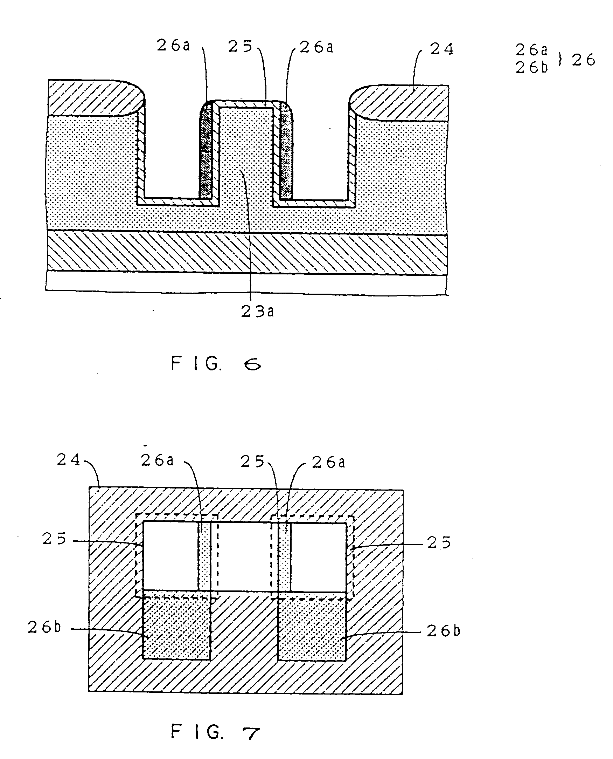

As shown in Fig. 4, boron (B) is ion-implanted to polysilicon layer 23 with a condition of 100 kV and 1 x 10¹¹ atoms/cm². Then, oxide films 24 are selectively formed at element isolation regions. Thereafter, trenches are formed at an element forming area by selective etching, using a reactive ion-etching method, so that a cross-section of the polysilicon layer at the element forming area has a figure as illustrated in Fig. 4.

The center portion of a cross-section of the polysilicon layer constitutes projection 23a (enclosed by the broken line in Fig. 4). The bottom portion of the cross-section constitutes polysilicon film 23b. Projection 23a has a rectangular figure having a width of 1 »m.

As shown in Fig. 5, gate oxide film 25 having a thickness of 200 Å Is formed using a dry oxide gas at 900 deg. Celsius.

As shown in Figs. 6 and 7, polysilicon layer 26, to which impurities are doped by an LPCVD method, is deposited on film 25, to thereby form layer 26 with a thickness of 2x10⁻⁴ mm (2000 Å). The side wall of projection 23a and a predetermined region at which a gate electrode will be formed are covered with a resist. Then, using a reactive ion-etching method, etching is performed so that polysilicon film 26a for the gate electrode remains at the side of projection 23a and polysilicon film 26b for a gate wiring electrode remains on oxide film 24.

As shown in Figs. 1 and 2, arsenic (As) for forming source region 27 and drain region 28 is selectively ion-implanted under the condition of 20 kV and 1 x 10¹⁵ atom/cm². (Incidentally, regions 27 and 28 may be drain and source, respectively.)

Thereafter, oxidation is performed, and contact holes are opened over the locations of source region 27 and drain region 28. Low resistivity polysilicons 29 obtained by doping impurities are inserted in the trenches using the LPCVD method. The wiring is performed by aluminum (Al) 30, so that source electrode 30S and drain electrodes 30D₁ and 30D₂ are formed.

The present invention is directed to the structure of the MOS FET shown in Fig. 1. On the main plane of semiconductor substrate 21, polysilicon projection 23a is formed via oxide film 22 and polysilicon film 23b. A pair of gate electrodes 26a face the both sides of projection 23a via gate oxide films 25. The upper and lower portions of projection 23a are provided with source and drain regions 27 and 28, respectively. Since the side wall of projection 23a is substantially perpendicular to the main plane of the substrate, a conductive channel forming area is formed at the side wall of projection 23a along the direction of the thickness of the substrate. An MOS FET structure having gate electrode 26a, gate oxide film 25, and the projection side wall can thus be formed, by which two vertical MOS FETs having a common source electrode can be obtained.

According to the MOS structure as mentioned above, it is possible to obtain a conductive channel forming area having a desired length, by adjusting the height of the projection, without changing the size in the lateral direction of the element forming area.

Further, according to the above MOS FET, even if a thermal diffusion of impurities of the source and drain regions occurs during various heat treatments, performed after the formation of the source and drain regions and before the completion of manufacturing the LSI, a problem of short-circuiting between the source and drain regions can be avoided, because the distance between the source and drain regions can be made large without lowering the integration density of the LSI. Thus, practical restrictions to the condition of heat treatments can be lowered while achieving the minimization of the device along the lateral direction. (For instance, when the lower limit of the lateral size is 10 »m in case of Fig. 9, the lower limit of the same can be less than 5 »m according to the configuration of Fig. 1.)

Incidentally, in the above embodiment, oxide film 22 and polysilicon film 23b are inserted between single crystal silicon substrate 21 and polysilicon projection 23a. The manufacturing method of the embodiment is such that after polysilicon film 23 is deposited, trenches are formed by a reactive ion-etching method, so that projection 23a and polysilicon film 23b are formed simultaneously.

## Claims

1. A semiconductor device having a MOS transistor structure, comprising:
a substrate (21) having a surface on which the MOS transistor structure is formed;
a film (22) formed on the surface of said substrate (21);
a projection (23a) of polysilicon of first conductivity type having grain boundaries and formed on the film (22), said projection having a side wall extending in a direction substantially perpendicular to the surface of said substrate (21), a bottom portion (23b) in contact with the film (22), and a top portion located opposite to the bottom portion;
a first semiconductor region (28) of second conductivity type formed on the film (22) and located in contact with the bottom portion (23b) of said projection (23a), said first region constituting the drain of said transistor structure;
a gate region (26a) located along the extending direction of the side wall of said projection (23a);
a second semiconductor region (27) of a second conductivity type located on top of and in contact with the top portion of said projection (23a) and constituting the source of said transistor structure; and
an insulating film (25) provided between the side wall of said projection (23a) and said gate region (26a).

2. A semiconductor device according to claim 1, wherein said projection (23a) has two side walls extending in the direction substantially perpendicular to the surface of said substrate (21), and said gate region (26a) includes a pair of gate electrodes (26a, 26a) which sandwich the side walls of said projection (23a), via said insulating film (25).

3. A semiconductor device according to claim 2, wherein said first region (28) contacts drain electrodes (30D₁, 30D₂) arranged at both sides of said projection (23a).

4. A semiconductor device according to claim 2 or 3, wherein said second region (27) contacts a source electrode (30S) arranged on the top portion of said projection (23a), said source electrode (30S) being located between the pair of said gate electrodes (26a, 26a).

## Patentansprüche

1. Halbleitervorrichtung mit einer MOS-Transistorstruktur, aufweisend:
- ein Substrat (21) mit einer Oberfläche, auf der die MOS-Transistorstruktur gebildet ist;
- einen Film (22), der auf der Oberfläche des Substrats (21) gebildet ist;
- einen Vorsprung (23a) aus Polysilizium des ersten Leitfähigkeitstyps, der Korngrenzen aufweist und auf dem Film (22) gebildet ist, wobei der Vorsprung eine Seitenwand, die sich in einer Richtung im wesentlichen senkrecht zur Oberfläche des Substrats (21) erstreckt, einen Bodenabschnitt (23b) in Berührung mit dem Film (22) und einen oberen Abschnitt aufweist, der gegenüber dem Bodenabschnitt angebracht ist;
- einen ersten Halbleiterbereich (28) des zweiten Leitfähigkeitstyps, der auf dem Film (22) gebildet und in Berührung mit dem Bodenabschnitt (23b) des Vorsprunges (23a) angebracht ist, wobei dieser erste Bereich den Drain der Transistorstruktur bildet;
- einen Gatterbereich (26a), der entlang der Erstreckungsrichtung der Seitenwand des Vorsprunges (23a) angeordnet ist;
- einen zweiten Halbleiterbereich (27) des zweiten Leitfähigkeitstyps, der auf dem oberen Abschnitt des Vorsprunges (23a) und in Berührung mit demselben angeordnet ist und die Source der Transistorstruktur bildet; und
- einen Isolierfilm (25), der zwischen der Seitenwand des Vorsprungs (23a) und dem Gatterbereich (26a) vorgesehen ist.

2. Halbleitervorrichtung nach Anspruch 1, bei der der Vorsprung (23a) zwei Seitenwände besitzt, die sich in Richtung im wesentlichen senkrecht zur Oberfläche des Substrats (21) erstrecken, und wobei der Gatterbereich (26a) ein Paar von Gatterelektroden (26a, 26a) aufweist, die durch den Isolierfilm (25) jeweils die Seitenwände des Vorsprungs (23a) zwischen sich bedecken.

3. Halbleitervorrichtung nach Anspruch 2, bei der der erste Bereich (28) die Drainelektroden (30D₁, 30D₂) berührt, die auf beiden Seiten des Vorsprunges (23a) angeordnet sind.

4. Halbleitervorrichtung nach Anspruch 2 oder 3, bei der der zweite Bereich (27) eine Sourceelektrode (30S) berührt, die auf dem oberen Abschnitt des Vorsprunges (23a) angeordnet ist, wobei die Sourceelektrode (30S) zwischen dem Paar der Gatterelektroden(26a, 26a) angebracht ist.

## Revendications

1. Dispositif à semiconducteurs ayant une structure de transistor MOS, comprenant:
un substrat (21) ayant une surface sur laquelle est formée la structure de transistor MOS;
un film (22) formé sur la surface dudit substrat (21);
une projection (23a) de silicium polycristallin d'un premier type de conductivité ayant des limites de drain et formée sur le film (22), ladite projection comportant une paroi latérale s'étendant dans une direction sensiblement perpendiculaire à la surface dudit substrat (21), une partie du bas (23b) en contact avec le film (22), et une partie du haut située à l'opposé de la partie du bas;
une première région semiconductrice (28) d'un second type de conductivité formée sur le film (22) et placée en contact avec la partie du bas (23b) de ladite projection (23a), ladite première région constituant le drain de ladite structure de transistor;
une région de grille (26a) située dans la direction d'extension de la paroi latérale de ladite projection (23a);
une seconde région semiconductrice (27) d'un second type de conductivité située en haut de et en contact avec la partie du haut de ladite projection (23a) et constituant la source de ladite structure de transistor; et,
un film isolant (25) prévu entre la paroi latérale de ladite projection (23a) et ladite région de grille (26a).

2. Dispositif à semiconducteurs selon la revendication 1, dans lequel ladite projection (23a) a deux parois latérales s'étendant dans la direction sensiblement perpendiculaire à la surface dudit substrat (21), et ladite région de grille (26a) inclut une paire d'électrodes de grille (26a,26a) qui mettent en sandwich les parois latérales de ladite projection (23a), par ledit film isolant (25).

3. Dispositif à semiconducteurs selon la revendication 2, dans lequel ladite première région (28) est en contact avec des électrodes de drain (30D₁, 30D₂) disposées des deux côtés de ladite projection (23a).

4. Dispositif à semiconducteurs selon la revendication 2 ou 3, dans lequel ladite seconde région (27) est en contact avec une électrode de source (30S) disposée sur la partie du haut de ladite projection (23a), ladite électrode de source (30S) étant située entre la paire desdites électrodes de grille (26a,26a).
